**Europäisches Patentamt**

(19) **European Patent Office**

**Office européen des brevets**

(11) Publication number : **0 293 297 B1**

(12) **EUROPEAN PATENT SPECIFICATION**

(45) Date of publication of patent specification :
25.01.95 Bulletin 95/04

(51) Int. Cl.⁶ : **H01L 23/473, H01L 23/42**

(21) Application number : **88401277.4**

(22) Date of filing : **25.05.88**

(54) **A system for cooling solid circuit components and a method for providing thermally conductive compound means therefor.**

(30) Priority : **25.05.87 JP 125732/87**
**23.06.87 JP 96288/87 U**

(43) Date of publication of application :
**30.11.88 Bulletin 88/48**

(45) Publication of the grant of the patent :
**25.01.95 Bulletin 95/04**

(84) Designated Contracting States :
**DE FR GB**

(56) References cited :
**EP-A- 0 151 068**
**US-A- 3 896 544**
**US-A- 4 644 385**
**PATENT ABSTRACTS OF JAPAN, vol. 10, no. 275 (E-438)[2331], 18th September 1986; & JP-A-61 97 953**
**IBM TECHNICAL DISCLOSURE BULLETIN, vol. 29, no. 4, September 1986, pages 1469-1470, New York, US; "Thermal grease module cap design"**
**IBM TECHNICAL DISCLOSURE BULLETIN, vol. 20, no. 11A, April 1978, pages 4391-4392, New York, US; S.E. GREER et al.: "Modified bellows conductive cooling"**

(73) Proprietor : **FUJITSU LIMITED**
**1015, Kamikodanaka**
**Nakahara-ku**
**Kawasaki-shi Kanagawa 211 (JP)**

(72) Inventor : **Suzuki, Masahiro**
**Sukai Haitsu 201**
**434, Higashinaganuma**
**Inagi-shi Tokyo 206 (JP)**
Inventor : **Yamamoto, Haruhiko**
**316-6-4-710, Mamedocho**
**Kohoku-ku**
**Yokohama-shi Kanagawa 222 (JP)**
Inventor : **Udagawa, Yoshiaki**
**25-6, Daita 4-chome**
**Setagaya-ku Tokyo 155 (JP)**

(74) Representative : **Joly, Jean-Jacques et al**
**Cabinet Beau de Loménie**
**158, rue de l'Université**
**F-75340 Paris Cédex 07 (FR)**

## Description

## BACKGROUND OF THE INVENTION

The present invention relates to cooling system used with a printed circuit board holding a number of solid electronic circuit components, such as integrated circuit (IC) semiconductor devices. More particularly, it relates to a cooling module, being included in the cooling system and contacting with each of the electronic circuit components through a thermally conductive compound layer to cool these components.

There have been developed various types of cooling structures for cooling IC semiconductor devices or large scale IC (LSI) semiconductor devices mounted on a printed circuit board as disclosed, for example, in U.S. Patents Nos. 3,993,123 (Chue et al.), 4,203,129 (Oktay et al.), 4,254,431 (Babuka et al.), and 4,323,914 (Berndmaier), and in not-examined provisionally published Japanese Patent Applications No. 61-15353 (invention by K.D. Ostergrane et al.). No. 60-160149 (invention by Yamamoto et al. equivalent to EP-A-015 10 68) and No. 62-109347 (invention by Tajima). In some of these cooling structures a heat transfer element, such as a heat transfer plate or a heat transfer piston, is placed in direct contact with the circuit components, being urged to a surface of a circuit component by pressure provided from a spring, bellows, hydraulic pressure of coolant, etc... to remove the heat dissipated from the circuit components. The heat transfer elements are exposed to a coolant directly or indirectly. The heat is transferred to the coolant through the corresponding heat transfer elements in contact with the circuit components.

In general, however, the heat contact resistance of an interface between the heat transfer elements and the circuit components in the above described cooling structures is rather high and unstable, because the actual contacting area therebetween is rather small and unstable due to the roughness of the surfaces which are thermally contacting with each other. In addition, any change of the pressure of the spring, bellows, and in particular the coolant pressure, affects the heat contact resistance delicately and seriously, resulting in a large loss of the heat transfer efficiency of the cooling modules. In particular, the use of a spring for urging a heat transfer member to the corresponding circuit component to be cooled, tends to cause mechanical resonant vibration triggered by an external mechanical shock, resulting in variation of the exerting pressure.

In order to overcome the aforesaid disadvantages of the prior art cooling structures, a thermal conductive material such as thermally conductive inert gas, or a liquid metal or thermal silicon grease, or a compliant thermal conductive material is inserted into the interface between the surfaces of a heat transfer element of a cooling module and a circuit component. For example, a thermally conductive inert gas is introduced into the interface by Chu et al., and a low boiling point liquid is utilized by Oktay et al. to immerse a heat transfer piston and a circuit component. However, in both cases a complicated and costly sealing structure for sealing the gas or the liquid is required, which constitutes a drawback. In addition, the thermal conductivity of the associated inert gas and liquid sets the reduction of the relevant thermal contact resistance within an upper limit.

While Berndlmaier et al. and Babuka et al. employ liquid metal or alloy to fill up a contact interface, Ostergrane disclose the use of thermal grease in the interface of conical surfaces of a piston and a hat, and the use of liquid metal layer between the piston and a circuit element. In this structure, a rather thick layer of thermal grease may be required to maintain the layer on the conical surface of the piston, causing undesirable increase in thermal resistance of the layer. In addition, some liquid metals usually have a probability of chemical reaction with contacting material, requiring various counter measures to prevent the reaction.

Yamamoto et al. insert a compliant sheet between a circuit component and a heat transfer plate urged toward the circuit component by a bellows to reduce thermal contact resistance across the interface between the component and the heat transfer plate. A relatively thick compliant sheet, however, is required in order to realize a desirable perfect thermal contact between the sheet surfaces and the contacting surfaces of the relevant circuit element and the heat transfer plate by expelling small air voids remaining on the contacting surfaces. As the result, the reduction of the whole thermal contact resistance across the interface is adversely affected. Tajima provides a cooling structure comprising a cap having a spherical top surface, a stud having a concave spherical bottom surface engageable with the spherical surface of the cap, and a cooling hat. The cap contacts with a circuit element with a small gap therebetween which is filled with thermal grease, while the stud is secured to a cooling header. The cap and the hat are in contact with each other through a layer of thermal grease which has a considerable thickness sufficient to protect the circuit element from being subject to a pressure. Tajima discloses nothing about pressure to be exerted to the thermal grease layer.

In these prior art cooling modules, much effort has been made to reduce the heat transfer resistance across a thermal contact interface utilizing various thermally conductive compound materials. However, the results are not sufficient to maintain a desirably low, stable and reproducible thermal contact resistance.

SUMMARY OF THE INVENTION

The primary object of the present invention is to eliminate the aforementioned drawbacks of the prior art cooling structures, and to provide a cooling system for an electronic circuit with a high performance cooling structure which can effectively, steadily, and uniformly cool circuit components contained in the circuit. The next object is to provide a stable and reliable cooling structure having a stabilized and thermally well-conductive compound means establishing a fluid type, for example a liquid type thermal contact between a heat transfer means and a circuit component.

To achieve the aforesaid objects, according to the present invention, the thermally conductive compound means is initially pressed with an initial pressure (Pm) that is substantially greater than the pressure required to reach a minimum heat contact resistance in the thermally conductive compound.

A first aspect of the invention relates to a cooling system capable of applying the above pressure conditions, as defined in claim 1, and a second aspect of the invention relates to a method for applying these conditions, as defined in claims 10 and 11.

Thus, according to the invention, at first, an experiment is previously conducted to define a critical pressure Pc, namely the minimum value of a pressure which is to be initially exerted to a layer of thermally conductive compound located in a thermal contact interface between a heat transfer plate and a circuit component. The relationship between the heat contact resistance across the interface and the pressure exerted thereon, represents a hysteresis characteristic . The heat contact resistance decreases as the initially exerted pressure Pi increases before exceeding a pressure, defined as a critical pressure Pc. Thereafter, the heat transfer resistance remains unchanged as the pressure is further increased till a maximum pressure Pm. Then, when pressure Pi is gradually decreased, the heat contact resistance of the thermal contact interface remains at the same value until the initial pressure Pi is reduced to a small value Pa approximately equal to zero pressure. The utilization of the above-described hysteresis characteristic between the pressure exerted on a thermally conductive compound layer and thermal contact resistance is the focus point of the present invention.

In practice, an initial pressure higher than an experimentally defined critical pressure Pc, is exerted to a thermally conductive compound layer which is already disposed in a thermal contact interface by using a jig or the hydraulic pressure of the associated coolant. A thus previously pressed thermally conductive compound has a favorably low heat contact resistance and is capable of maintaining the value of said resistance in a stable manner under a low pressure, as discovered by the inventors by conducting and repeating a number of experiments and practices.

As a result, during the operation of the relevant electronic circuit, a pressure Pa lower than the initially exerted pressure Pm but higher than zero, is exerted in the thermal interface sufficiently to maintain a small heat contact resistance across the interface, enabling a stable and effective heat removal from the relevant components. Of course, when the electronic circuit is out of operation, the pressure Pa is exerted onto the circuit element. Hereinafter, therefore, the pressure Pa is referred to as a working pressure. In the case of a multi-chip printed circuit board having a number of components mounted thereon, pressurizing jigs of two types for exerting the initial pressure Pi to the thermally conductive compound layers are disclosed in a first and a second embodiments. The use of the hydraulic pressure of the associated coolant for processing the thermally conductive compound layer is disclosed in a third embodiment. Means for preventing the thermally conductive compound from flowing off the located interface is disclosed in a fourth embodiment. In all the embodiments, bellows are used as a resilient member for elastically pressing the heat transfer plate toward the corresponding circuit component in combination with the hydraulic pressure of a fluid coolant.

The thermally conductive compound is selected from a thermal grease, favorably a thermal silicon grease. The features and the advantages of the present invention will be apparent from the following description made with reference to the drawings where like reference numerals denote identical or similar parts.

BRIEF DESCRIPTION OF THE DRAWINGS

Fig. 1 is a schematic magnified cross-sectional view of a thermal contact interface containing a thermally conductive compound layer therein, for explaining heat transfer thereacross.

Fig. 2 is a schematic cross-sectional view of an experimental apparatus for studying the relationship between the heat contact resistance across the thermal contact interface of Fig. 1 and the pressure exerted thereon.

Fig. 3 is a diagram representing the result of an experimental test conducted by using the apparatus of Fig. 2.

Fig. 4 is a schematic cross-sectional view of a cooling module according to the present invention, illustrating a typical structural configuration thereof.

Figs. 5(a) and 5(b) are schematic cross-sectional views of a part of a cooling system according to the present invention, illustrating the structural configuration thereof and a method of pressing the thermally conductive compound layer according to a first embodiment of the invention.

Figs. 6(a) and 6(b) are schematic cross-sectional views of a part of a cooling system according to the present invention, illustrating the structural configuration thereof and a method of pressing the thermally conductive compound layer according to a second embodiment of the invention,

Fig. 7 is a schematic cross-sectional view of a part of a cooling system according to the present invention, illustrating its structural configuration and a method of pressing the thermally conductive compound layer according to a third embodiment of the invention, and

Fig. 8 is a perspective view of circuit components mounted on a printed circuit board, illustrating its structural configuration of a barrier means according to a further embodiment of the present invention.

## DESCRIPTION OF PREFERRED EMBODIMENTS

Generally, the thermal contact resistance across any interface between two surfaces of bodies is a function of the contacting area, surface finishing and flatness, and applied load between the surfaces. Actual contacting area varies depending on the above-described factors except the filling material. In most applications, improvement in the surface finish and flatness is expensive in this field and is not economical. Therefore, a thermally conductive layer is interposed between the two surfaces, filling small gaps in the interface area and expelling air micro-voids remaining on the surfaces, to reduce the thermal contact resistance across the interface.

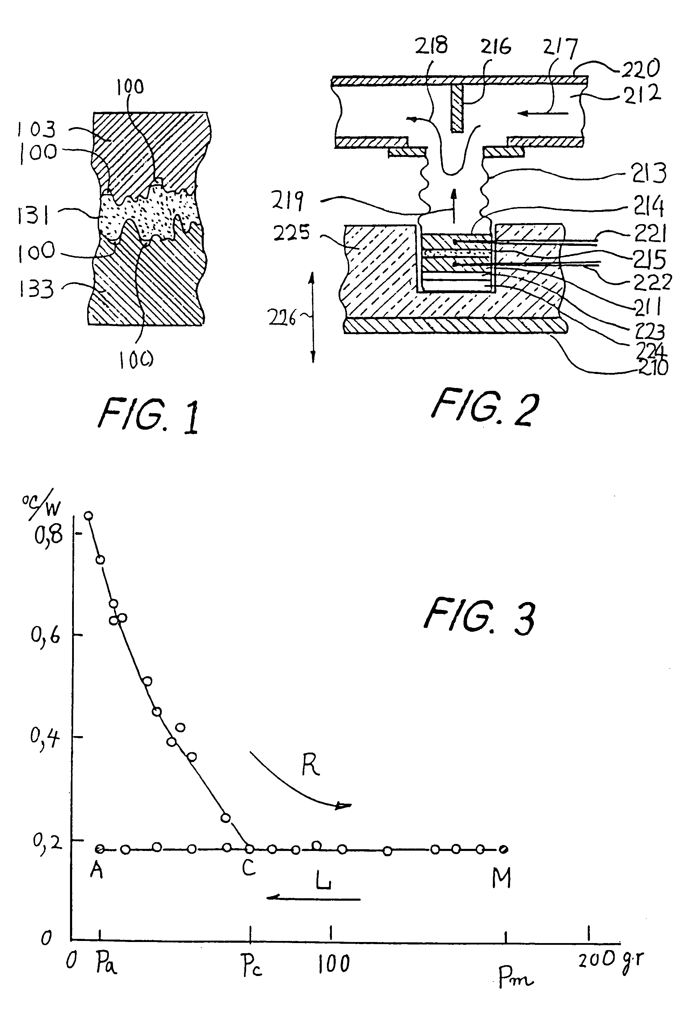

Fig. 1 is a magnified cross-sectional view of the interface between the surfaces of a heat transfer plate 103 and a circuit component 133 thermally contacting with each other through a layer of a thermally conductive compound 131, typically a thermal grease. The roughness and irregularities ranging below 1 μm of both surfaces are inevitable, resulting in a number of micro-voids 100 where air tends to be trapped. Thermal contact resistance across the interface can be reduced by eliminating the trapped air and replacing it with thermal grease 131, such as silicon oil which has a thermal conductivity several times higher than that of air. Usually, the viscosity of the thermal grease is adjusted so that the thermal grease is semi-flowable, for keeping a paste-like consistency. The thermal grease 131 contains fillers consisting of fine particles of metal oxides or ceramics, suspending in a carrier fluid such as silicon oil. Increase in the mutual contact between the fine particles, or between the fine particles and the surfaces of the interface, is considered to reduce the thermal contact resistance of the interface filled with the thermally conductive compound layer. According to an accumulated experience of the inventors, the heat contact resistance across a thermal contact interface containing a thermally conductive compound therein has a relationship with the pressure exerted showing hysteresis characteristics thereon, as mentioned before.

Fig. 2 is a schematic cross-sectional view of an experimental apparatus for studying the relationship between resistance and pressure. In the apparatus, a first copper disk plate 214, a layer of thermal grease 215, a second copper disk plate 211, a heater disk 223, and a load sensor 224 are coaxially stacked in the recited order forming a cylinder block which is surrounded by a thick thermal insulator layer 225 for thermally insulating the bottom side and the cylindrical side of the block. A coolant passage 212, namely a water passage, is disposed in a cooling header 220. The first copper disk plate 214 is connected to one end of a bellows 213 which is water tightly secured to the cooling header 220 at the other end, being operatively connected to the coolant passage 212. The coolant water flows through the coolant passage 212 as indicated by the arrow 217, and then the flow direction is turned toward the first copper disk 214 by means of a deflector 216 disposed inside of the water passage 212, as indicated by the arrow 218, removing heat generated in the heater disk 223. Consequently, the cooling header 220 is fixed and the cylindrical block is vertically movable by the vertical movement of a table 210 on which the thermal insulator 225 and the cylinder block are placed.

By the structure of the above-described configuration, the whole heat generated in the heater disk 223 can be considered in good approximation to flow in an upward direction as indicated by the arrow 219. The temperature $t_1$ of the first copper disk plate 214 and the temperature $t_2$ of the second copper disk plate 211 are measured by thermocouples 221 and 222 attached to the disk plates 214 and 211 respectively. Thus the heat contact resistance Rcont of the thermal interface including the thermal grease layer 215 can be easily figured out by measuring the temperatures $t_1$ and $t_2$, and the heating power Q inputted to the heater disk 223, according to the following formula :

$$Rcont = (t_2 - t_1)/ Q$$

The load pressure P applied to the thermal grease layer 215 is detected by a load sensor 224, in the form of a piezoresistive device such as a silicon pressure transducer available in the market. Consequently, the pressure exerted to the thermal grease 215 is the sum of the hydraulic pressure of the coolant and the resilient pressure of the bellows 213. The hydraulic pressure is changeable using a hydraulic pump and a piping line (both not shown), and the resilient pressure of the bellows 213 can be changed in some range by adjusting the vertical position of the base table 210 upwardly or downwardly as indicated by the twin heads arrow 226.

Fig. 3 is a diagram representing an experimental result. The heat contact resistance Rcont is taken on the coordinate and the load pressure P on the abscissa. At the beginning of the experiment, the load pressure P is gradually increased from zero to a maximum pressure Pm and kept for 3 minutes at Pm. Thereafter, the load pressure P is gradually reduced toward zero value. Each experimental datum is plotted as indicated by a small circle, initially in the rightward direction as indicated by the arrow R, and, after reaching a point M, toward the leftward direction as indicated by the arrow L. Apparently, the curve of Fig. 3 represents a hysteresis character. The curve has a turning point C at a load pressure which is referred to as a critical pressure Pc. At a pressure higher than Pc, the heat contact resistance remains unchanged, being maintained until the load pressure P is increased to Pm, and then decreased from Pm to Pa near the zero value. It is confirmed that the heat contact resistance at a load pressure of 10 gram, as indicated by a point A, is still almost the same value as that at a higher load pressure. This hysteresis character is fully utilized in the present invention.

Basically, the present invention relates to a printed circuit board mounting a number of circuit components such as IC chips thereon, namely a multi-chips printed circuit board. At first, however, a single cooling module applied to a single chip and an associated thermally conductive compound layer, will be described to explain the principle of the present invention.

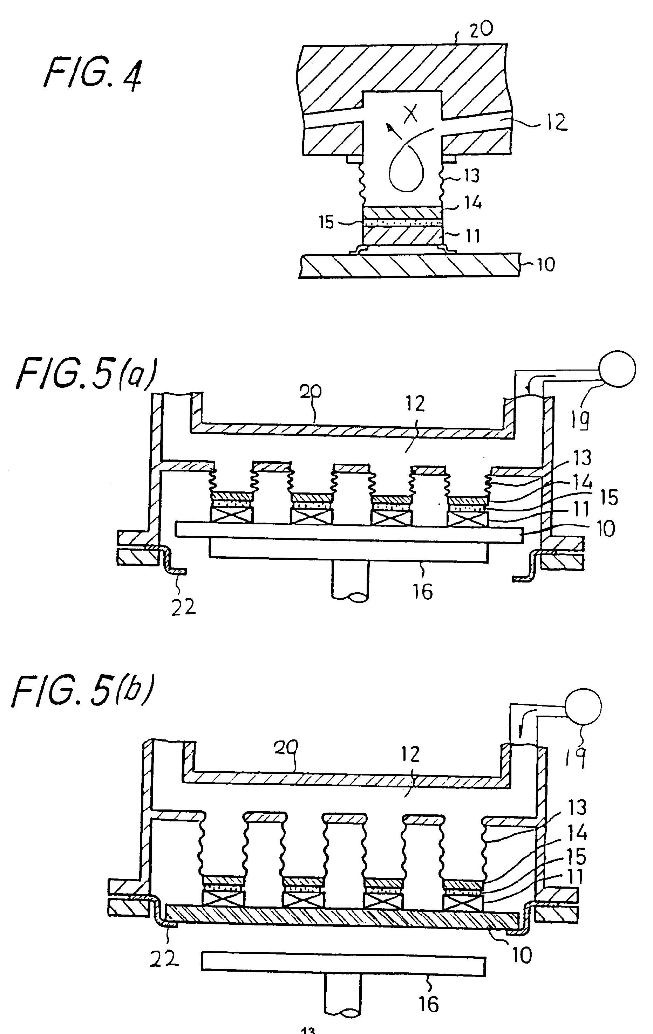

Fig. 4 is a schematic cross-sectional view of a cooling module, illustrating its structural configuration. Corresponding to the cooling module, a circuit component 11, such as a semiconductor IC device, is mounted on a printed circuit board 10. A thermally conductive compound layer 15, such as a layer of thermal grease, is interposed between the top surface of the circuit component 11 and a heat transfer plate 14 made of metal having high thermal conductivity, such as copper. The heat transfer plate 14 is liquid tightly connected at one end of a bellows 13. At its other end the bellows 13 is tightly secured to a cooling header 20, being operatively connected to a coolant passage 12 disposed in the cooling header 20. The coolant, which may be a liquid coolant or a gaseous coolant, flows through the coolant passage 12, contacting the exposed surface of the heat transfer plate 14. The flow of the coolant is directed toward the heat transfer plate 14 guided by the coolant passage 12 as represented by the arrow X such that the heat generated in the circuit component 11 and transferred to the heat transfer plate 14 across the thermally conductive compound layer 15, is effectively removed by the coolant. The thermal conductive compound layer 15 may be coated on the top surface of the circuit component 11 or on the bottom surface, facing the circuit component 11, of the heat transfer plate 14. As a result, both surfaces come in full contact with each other even when they are uneven and rough.

Thus, the cooling header 20 is fixed, and the stacked block comprising the heat transfer plate 14, thermally conductive compound layer 15 and circuit component 11 is vertically moved to exert a pressure to the thermally conductive compound layer 15 by vertically moving the printed circuit board 10. With the above-described structure of the cooling module, the thermally conductive compound layer 15 can be pressed before operation in order to enhance and stabilize the thermal conductivity of the layer 15 in the manner as described before with respect to the experiment the result of which is represented in Fig. 3. That is, the layer 15 is pressed by elevating the printed circuit board 10 or by increasing the hydraulic pressure of the coolant, or by combining both operations, to a pressure Pm higher than the critical pressure Pc which is determined by an experiment conducted beforehand. The pressure Pm is maintained for a predetermined time, usually for three minutes. Thereafter, the pressure is decreased from the pressure Pm to a working pressure Pa which may be slightly higher than zero. However, in practice, the working pressure Pa is selected to a higher value sufficient to absorb an inevitable fluctuation of the relevant hydraulic pressure of the coolant or the elastic pressure of the bellows. Thus the thermally conductive compound layer 15 establishes a compound contact or grease contact between the heat transfer plate 14 and the circuit component 11.

Figs. 5(a) and 5(b) are substantially schematic, partial cross-sectional views of a cooling system according to a first embodiment of the present invention, illustrating a series of cooling modules for corresponding circuit components 11 mounted on a multi-chips printed circuit board 10. The cooling modules are connected to a fixed cooling header 20 through which a coolant passage 12 is disposed. The coolant is pressurized by a hydraulic pump 19 of the relevant cooling system (not wholly shown) of the electronic circuit apparatus, running through the coolant passage 12, and removing heat generated in each circuit component 11 through the corresponding cooling module. Each cooling module comprises a bellows 13 fixed to the cooling header 20 at one end, being operatively connected to the coolant passage 12, and to a heat transfer plate 14 at the other end. The printed circuit board 10 is supported at its peripheral edge by a flange 22 which is secured to the lower portion of the cooling header 20. The axes of cooling modules are arranged vertically to the corresponding circuit components 11. Thermally conductive compound, such as silicon thermal grease available in the market, is coated to form a layer 15 on the top surface of the circuit component 11 or on the bottom surface of the heat transfer plate 14. Then, the printed circuit board 10 is vertically elevated using a movable base plate jig 16, namely a table elevator, and is pressed against the cooling modules. Thus, each circuit component 11 is pressed against the corresponding heat transfer plates 14, exerting a pressure P to each thermally conductive compound layer 15, as shown in Fig. 5(a). The pressure P is increased up to Pm higher than the critical pressure Pc which is defined by an experiment conducted precedingly. The pressure Pm is maintained for a time, for instance three minutes, and thereafter, the base table 16 is lowered decreasing the pressure P until the printed circuit board 10 is held again by the flange 22 as shown in Fig. 5(b). The printed circuit board 10 is fixed to the flange 22. In this situation, a working pressure Pa higher than zero is provided to the thermally conductive compound layer 15. As the result, a stable and high heat transfer from the circuit component 11 to the coolant is established, providing the relevant electronic circuit apparatus with high reliability.

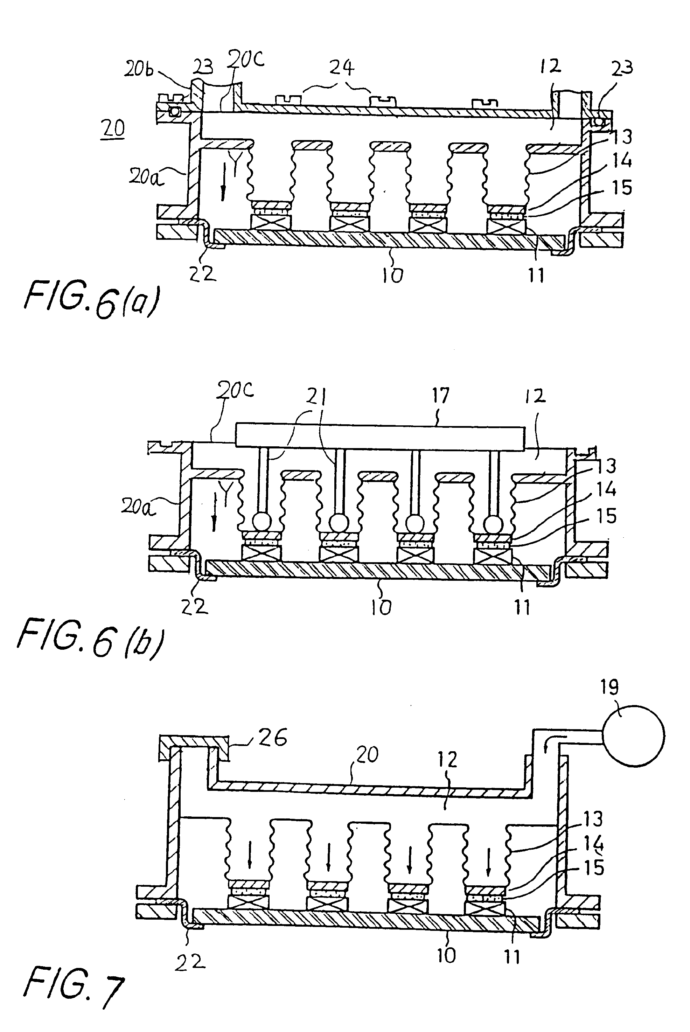

Figs. 6(a) and 6(b) are substantially schematic cross-sectional views of a cooling system according to a second embodiment according to the present invention, illustrating a series of cooling modules engaging with the corresponding circuit components 11 mounted on a multi-chip printed circuit board 10. In this second embodiment, the cooling header 20 is separable into a lower cooling header 20a and an upper cooling header 20b. The lower cooling header 20a has an opening 20c in the upper portion thereof. The relevant heat transfer plates 14 are pushed downwardly as indicated by arrow Y with a pushing jig 17, pressing each thermally conductive compound layers 15 interposed between the top surface of the circuit components 11 and the heat transfer plates 14, against the corresponding circuit components 11. The pushing jig 17 has a plural number of rods 21 having a ball shaped tip at each end, and each rod 21 is inserted into each bellows 13 through the opening 20c of the lower cooling header 20b, pressing each heat transfer plate 14 connected to the bellows 13 against the circuit components 11 (Fig. 6(b). The pushing jig 21 is driven by a mechanical power source (not shown) such that the thermally conductive compound layers 15 are subject to a pressure changing according to the same time schedule as that of the preceding embodiment. Then, the opening 20c of the lower cooling header 20a is water-tightly closed by the upper cooling header 20b, namely a header cover, utilizing an "0" ring 23 and screws 24 in a conventional manner (Fig. 6(a)). The effect of thus treated thermally conductive compound layer 15 is the same as that described in connection with the first embodiment.

Fig. 7 is a substantially schematic cross-sectional view of a cooling system according to a third embodiment of the present invention, illustrating a series of cooling modules for the corresponding circuit components 11 mounted on a multi-chip printed circuit board 10. In this third embodiment, the structural configuration of the cooling system is the same as that of the first embodiment. However, instead of pressing jigs used in the preceding embodiments, the hydraulic pressure of the coolant is used by controlling the relevant hydraulic pump 19 connected to an opening of a cooling head such that the thermally conductive compound layer 15 can be subject to a pressure varying according to a similar time schedule as in the first and the second embodiments. The other opening of the cooling header 20 is closed by a stopping cover 26 as shown in figure 7, or by using a stop valve (not shown). The output pressure of the pump 19 is controlled by controlling a driving motor (not shown) such that the above described pressurizing pattern is achieved. The effect of the cooling modules is the same as in the preceding embodiments. Although an adjustment of the hydraulic pressure by controlling the relevant hydraulic pump is necessary, the initial pressing of the thermally conductive compound layer can be easily performed by the method according to the third embodiment.

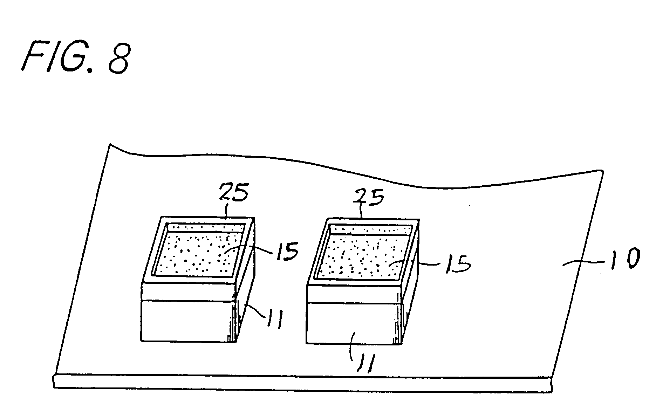

Fig. 8 is a perspective view of circuit components 11 mounted on a printed circuit board 10 having square ring-shaped barrier means 25 disposed on the top surface of the circuit components 11, for preventing thermally conductive compound layers 15 from flowing away from the area where they are initially provided. The barrier means 25 is formed to surround said area, and may be formed in a single piece body with the circuit component 11 on the top surface thereof, or may be formed separately using a material such as ceramic, silicon rubber, etc. and be adhesively disposed on the top surface of the circuit component 11. The height of the barrier 25 is selected to be slightly smaller than the thickness of the thermally conductive layer 15 in order to enable the compound layer to be pressed afterwards. The barrier means 25 may be formed on the bottom surface of the associated heat transfer plate 14 (see Figs. 5(a)-5(b), 6(a)-6(b), and 7).

## Claims

1. A cooling system used with a printed circuit board (10) having at least one solid circuit component (11), said cooling system comprising :

a cooling header(20) having a coolant passage (12) disposed thereinside,

a heat transfer means (14) operatively connected to said cooling header such that at least a part of said heat transfer means is exposed to a liquid coolant flowing through said coolant passage and such that heat may be transferred from said heat transfer means to said liquid coolant ;

an elastic means (13), connected to said heat transfer means and said cooling header, and pressure means (19) for biasing said heat transfer means against said solid circuit component with a working pressure (Pa) higher than zero pressure, and

a thermally conductive compound means (15), disposed between said heat transfer means and said solid circuit component, establishing a thermal contact between said heat transfer means and said solid circuit component, characterized in that it further comprises overpressure means (19; 17, 21) to releasably exert a pressure (Pm) on said thermally conductive compound means (15) that is substantially greater than the pressure (Pc) required to reach a minimum heat contact resistance value in said thermally conductive compound means (figure 3).

2. A cooling system according to claim 1, wherein said thermally conductive compound means (15) is a thermal silicone grease.

3. A cooling system according to claim 1 or 2, wherein said heat transfers means (14) and said elastic means (13) compose a cooling module.

4. A cooling system according to any one of claims 1 to 3, wherein said elastic means is a bellows (13).

5. A cooling system according to any one of claims 1 to 4, wherein said heat transfer means is a plate (14) made of metal and having a high thermal conductivity.

6. A cooling system according to any one of claims 1 to 5, wherein said overpressure means (19) comprises

a hydraulic pump (19) operatively connected to said cooling header (20), pressurizing said liquid coolant and enabling said liquid coolant to flow through said coolant passage (12).

7. A cooling system according to claim 6, wherein said working pressure is provided by said elastic means (13) and said hydraulic pressure of said liquid coolant provided by said hydraulic pump (19).

8. A cooling system according to any one of claims 1 to 7, wherein it further comprises a barrier means (25) disposed on a surface of said solid circuit component (11), surrounding the area where said thermally conductive compound means (15) is provided.

9. A cooling system according to any one of claims 1 to 8, wherein said cooling header (20) is separable into a lower member (20a) having an opening (20c) and an upper member (20b) capable of closing said opening of said lower member in a liquid tight manner.

10. A method of providing a thermally conductive compound means (15) to reduce and stabilize the thermal contact resistance between a first member (14) and a second member (11) having respective first and second surfaces facing each other with said thermally conductive compound material being interposed between said first surface and said second surface, and with said first member and said second member being pressed to each other, characterized by the steps of:

pressing said first and second members and said thermally conductive compound means in between to each other with an initial pressure (Pm) that is substantially greater than the pressure (Pc) required to reach a minimum heat contact resistance in said thermally conductive compound means ; and

reducing said initial pressure (Pm) to a working pressure (Pa) higher than zero pressure (Fig. 3).

11. A method of providing a thermally conductive compound means in a cooling system used with a printed circuit board (10) having at least one solid circuit component (11), said cooling system including a cooling header (20) having a coolant passage (12) disposed thereinside, a hydraulic pump (19) operatively connected to said coolant passage for pressurizing a liquid coolant to flow through said coolant passage, and a cooling module disposed corresponding to said solid circuit component, said cooling module comprising a heat transfer means (14) operatively connected to said cooling header (20) such that at least a part of said heat transfer means is exposed to the flow of said liquid coolant and such that heat may be transferred from said heat transfer means to said liquid coolant and an elastic means (13) connected to said heat transfer means and said coolant header, for biasing said heat transfer means against said solid circuit component with a working pressure (Pa) higher than zero pressure, said thermally conductive means being disposed between said heat transfer means and said solid circuit component and establishing a thermal contact there-between, said method being characterized by the steps of

pressing said heat transfer means (14) to said solid circuit component (11) with said thermally conductive compound means (15) in between with an initial pressure (Pm) that is substantially greater than the pressure (Pc) required to reach a minimum heat contact resistance in said thermally conductive compound means (figure 3.) ; and

reducing said initial pressure to said working pressure (Pa) which is lower than said initial pressure ;

whereby a reduced and stabilized thermal contact resistance is provided between said heat transfer means (14) and said solid circuit component (11) under said working pressure (Pa).

12. A method according to claim 11, wherein said initial pressure is provided to said thermally conductive compound means by pressing said printed circuit board (10) against said cooling module.

13. A method according to claim 12, wherein said printed circuit board (10) is moved towards said cooling module using a table elevator.

14. A method according to claim 11, wherein said cooling header (20) is separable into a lower member (20a) having an opening and an upper member (20b) capable of closing said opening of said lower member in a liquid tight manner, and said initial pressure is provided to said thermally conductive compound means by mechanically pushing said heat transfer means against said circuit component using a pushing jig which is inserted inside said lower cooling header by removing said upper cooling header.

15. A method according to claim 11, wherein said initial pressure exerted on said thermally conductive compound means (15) is varied by controlling said hydraulic pressure of said coolant using said hydraulic pump (19) and means (26) for stopping the flow of said coolant.

**Patentansprüche**

1. Ein Kühlsystem, das mit einer gedruckten Leiterplatte (10) verwendet wird, die wenigstens eine feste Schaltungskomponente (11) hat, welches Kühlsystem umfaßt:

ein Kühlgehäuse (20) mit einem Kühlmitteldurchgang (12), der in ihm angeordnet ist;

ein Wärmeübertragungsmittel (14), das mit dem genannten Kühlgehäuse operativ verbunden ist, so daß wenigstens ein Teil des genannten Wärmeübertragungsmittels einem flüssigen Kühlmittel ausgesetzt ist, das durch den genannten Kühlmitteldurchgang strömt, und daß Wärme von dem genannten Wärmeübertragungsmittel zu dem genannten flüssigen Kühlmittel übertragen werden kann;

ein elastisches Mittel (13), das mit dem genannten Wärmeübertragungsmittel und dem genannten Kühlgehäuse verbunden ist, und ein Druckmittel (19) zum Vorspannen des genannten Wärmeübertragungsmittels gegen die genannte feste Schaltungskomponente mit einem Arbeitsdruck (Pa), der höher als der Null-Druck ist; und

ein wärmeleitfähiges Verbindungsmittel (15), das zwischen dem genannten Wärmeübertragungsmittel und der genannten festen Schaltungskomponente angeordnet ist und einen Wärmekontakt zwischen dem genannten Wärmeübertragungsmittel und der genannten festen Schaltungskomponente herstellt, dadurch gekennzeichnet, daß es ferner ein Überdruckmittel (19; 17, 21) umfaßt, um auf das genannte wärmeleitfähige Verbindungsmittel (15) freigebbar einen Druck (Pm) auszuüben, der wesentlich größer als der Druck (Pc) ist, der erforderlich ist, um einen minimalen Wärmekontaktwiderstandswert in dem genannten wärmeleitfähigen Verbindungsmittel zu erreichen (Figur 3).

2. Ein Kühlsystem nach Anspruch 1, bei dem das genannte wärmeleitfähige Verbindungsmittel (15) ein Thermosilikonfett ist.

3. Ein Kühlsystem nach Anspruch 1 oder 2, bei dem das genannte Wärmeübertragungsmittel (14) und das genannte elastische Mittel (13) einen Kühlmodul bilden.

4. Ein Kühlsystem nach irgendeinem der Ansprüche 1 bis 3, bei dem das genannte elastische Mittel ein Balgen (13) ist.

5. Ein Kühlsystem nach irgendeinem der Ansprüche 1 bis 4, bei dem das genannte Wärmeübertragungsmittel eine Platte (14) ist, die aus Metall besteht und eine hohe Wärmeleitfähigkeit hat.

6. Ein Kühlsystem nach irgendeinem der Ansprüche 1 bis 5, bei dem das genannte Überdruckmittel (19) eine hydraulische Pumpe (19) umfaßt, die mit dem genannten Kühlgehäuse (20) operativ verbunden ist, das genannte flüssige Kühlmittel unter Druck setzt und ermöglicht, daß das genannte flüssige Kühlmittel durch den genannten Kühlmitteldurchgang (12) strömt.

7. Ein Kühlsystem nach Anspruch 6, bei dem der genannte Arbeitsdruck durch das genannte elastische Mittel (13) vorgesehen wird und der genannte hydraulische Druck des genannten flüssigen Kühlmittels durch die genannte hydraulische Pumpe (19) vorgesehen wird.

8. Ein Kühlsystem nach irgendeinem der Ansprüche 1 bis 7, welches ferner ein Begrenzungsmittel (25) umfaßt, das auf einer Oberfläche der genannten festen Schaltungskomponente (11) angeordnet ist und den Bereich umgibt, in dem das genannte wärmeleitfähige Verbindungsmittel (15) vorgesehen ist.

9. Ein Kühlsystem nach irgendeinem der Ansprüche 1 bis 8, bei dem das genannte Kühlgehäuse (20) trennbar ist in ein unteres Glied (20a), das eine Öffnung (20c) hat, und ein oberes Glied (20b), das die genannte Öffnung des genannten unteren Glieds flüssigkeitsdicht verschließen kann.

10. Ein Verfahren zum Vorsehen eines wärmeleitfähigen Verbindungsmittels (15), um den Wärmekontaktwiderstand zwischen einem ersten Glied (14) und einem zweiten Glied (11) zu reduzieren und zu stabilisieren, die jeweilige erste und zweite Oberflächen haben, die einander zugewandt sind, bei dem das genannte wärmeleitfähige Verbindungsmaterial zwischen der genannten ersten Oberfläche und der genannten zweiten Oberfläche eingefügt ist, und das genannte erste Glied und das genannte zweite Glied aneinandergepreßt werden, gekennzeichnet durch die Schritte:

Aneinanderpressen der genannten ersten und zweiten Glieder mit dem genannten wärmeleitfähigen Verbindungsmittel dazwischen mit einem Anfangsdruck (Pm), der wesentlich größer als der Druck (Pc) ist, der erforderlich ist, um einen minimalen Wärmekontaktwiderstand in dem genannten wärmeleitfähigen Verbindungsmittel zu erreichen; und

Reduzieren des genannten Anfangsdrucks (Pm) auf einen Arbeitsdruck (Pa), der höher als der Null-Druck ist (Fig. 3).

11. Ein Verfahren zum Vorsehen eines wärmeleitfähigen Verbindungsmittels in einem Kühlsystem, das mit einer gedruckten Leiterplatte (10) verwendet wird, die wenigstens eine feste Schaltungskomponente (11) hat, welches Kühlsystem ein Kühlgehäuse (20) enthält, das einen Kühlmitteldurchgang (12) hat, der in ihm angeordnet ist, eine hydraulische Pumpe (19), die mit dem genannten Kühlmitteldurchgang operativ verbunden ist, zum Unterdrucksetzen eines flüssigen Kühlmittels, um durch den genannten Kühlmitteldurchgang zu strömen, und einen Kühlmodul, der entsprechend der genannten festen Schaltungskomponente angeordnet ist, welcher Kühlmodul ein Wärmeübertragungsmittel (14) umfaßt, das mit dem genannten Kühlgehäuse (20) operativ verbunden ist, so daß wenigstens ein Teil des genannten Wärmeübertragungsmittels der Strömung des genannten flüssigen Kühlmittels ausgesetzt ist, und daß Wärme von dem genannte Wärmeübertragungsmittel zu dem genannten flüssigen Kühlmittel übertragen werden kann, und ein elastisches Mittel (13), das mit dem genannten Wärmeübertragungsmittel und dem genannten Kühlgehäuse verbunden ist, zum Vorspannen des genannten Wärmeübertragungsmittels gegen die genannte feste Schaltungskomponente mit einem Arbeitsdruck (Pa), der höher als die Drucklosigkeit ist, bei dem das genannte wärmeleitfähige Mittel zwischen dem genannten Wärmeübertragungsmittel und der genannten festen Schaltungskomponente angeordnet ist und zwischen ihnen einen Wärmekontakt herstellt, welches Verfahren gekennzeichnet ist durch die Schritte:

Pressen des genannten Wärmeübertragungsmittels (14) an die genannte feste Schaltungskomponente (11) mit dem genannten wärmeleitfähigen Verbindungsmittel (15) dazwischen mit einem Anfangsdruck (Pm), der wesentlich größer als der Druck (Pc) ist, der erforderlich ist, um einen minimalen Wärmekontaktwiderstand in dem genannten wärmeleitfähigen Verbindungsmittel zu erreichen (Figur 3); und

Reduzieren des genannten Anfangsdrucks auf den genannten Arbeitsdruck (Pa), der niedriger als der genannte Anfangsdruck ist;

wodurch ein reduzierter und stabilisierter Wärmekontaktwiderstand zwischen dem genannten Wärmeübertragungsmittel (14) und der genannten festen Schaltungskomponente (11) unter dem genannten Arbeitsdruck (Pa) vorgesehen wird.

12. Ein Verfahren nach Anspruch 11, bei dem der genannte Anfangsdruck für das genannte wärmeleitfähige Verbindungsmittel vorgesehen wird, indem die genannte gedruckte Leiterplatte (10) gegen den genannten Kühlmodul gedrückt wird.

13. Ein Verfahren nach Anspruch 12, bei dem die genannte gedruckte Leiterplatte (10) unter Verwendung eines Tischhebers hin zu dem genannten Kühlmodul bewegt wird.

14. Ein Verfahren nach Anspruch 11, bei dem das genannte Kühlgehäuse (20) trennbar ist in ein unteres Glied (20a), das eine Öffnung hat, und ein oberes Glied (20b), das die genannte Öffnung des genannten unteren Glieds flüssigkeitsdicht verschließen kann, und der genannte Anfangsdruck für das genannte wärmeleitfähige Verbindungsmittel vorgesehen wird, indem das genannte Wärmeübertragungsmittel gegen die genannte Schaltungskomponente unter Verwendung einer Schiebevorrichtung geschoben wird, die in das genannte untere Kühlgehäuse eingefügt wird, indem das genannte obere Kühlgehäuse entfernt wird.

15. Ein Verfahren nach Anspruch 11, bei dem der genannte Anfangsdruck, der auf das genannte wärmeleitfähige Verbindungsmittel (15) ausgeübt wird, durch Steuern des genannten hydraulischen Drucks des genannten Kühlmittels unter Verwendung der genannten hydraulischen Pumpe (19) und das Mittel (26) zum Stoppen der Strömung des genannten Kühlmittels verändert wird.

## Revendications

1. Système de refroidissement utilisé avec une carte à circuit imprimé (10) possédant au moins un composant de circuit du type solide (11), ledit système de refroidissement comprenant :

un collecteur de refroidissement (20) à l'intérieur duquel est disposé un passage (12) pour agent de refroidissement,

un moyen (14) de transfert de chaleur qui est fonctionnellement connecté audit collecteur de refroidissement de façon qu'au moins une partie du moyen de transfert de chaleur soit exposée à un agent de refroidissement liquide circulant dans ledit passage pour agent de refroidissement et de façon que de la chaleur puisse être transférée dudit moyen de transfert de chaleur audit agent de refroidissement liquide,

un moyen élastique (13), connecté audit moyen de transfert de chaleur et audit collecteur d'agent de refroidissement, et un moyen d'application de pression (19) servant à solliciter ledit moyen de transfert de chaleur à venir contre ledit composant de circuit du type solide avec une pression de travail (Pa) qui est supérieure à la pression zéro, et

un moyen formant un composé thermiquement conducteur (15), qui est disposé entre ledit moyen de transfert de chaleur et ledit composant de circuit du type solide, ce moyen établissant un contact thermique entre ledit moyen de transfert de chaleur et ledit composant de circuit du type solide,

caractérisé en ce qu'il comprend en outre un moyen d'application de surpression (19, 17, 21) qui exerce, de façon amovible, sur ledit moyen formant un composé thermiquement conducteur (15) une pression initiale (Pm) sensiblement supérieure à la pression (Pc) nécessaire pour atteindre une valeur minimale de résistance de contact thermique dans ledit moyen formant un composé thermiquement conducteur (figure 3).

2. Système de refroidissement selon la revendication 1, où ledit moyen (15) formant un composé thermiquement conducteur est une graisse de silicone thermique.

3. Système de refroidissement selon la revendication 1 ou 2, où ledit moyen de transfert de chaleur (14) et ledit moyen élastique (13) composent un module de refroidissement.

4. Système de refroidissement selon l'une quelconque des revendications 1 à 3, où ledit moyen élastique est un soufflet (13).

5. Système de refroidissement selon l'une quelconque des revendications 1 à 4, où ledit moyen de transfert de chaleur est une plaque (14) faite de métal et ayant une conductivité thermique élevée.

6. Système de refroidissement selon l'une quelconque des revendications 1 à 5, où ledit moyen d'application de surpression (19) comprend une pompe hydraulique (19) fonctionnellement connectée audit collecteur de refroidissement (20), qui met en pression ledit agent de refroidissement liquide et permet audit agent de refroidissement liquide de circuler dans ledit passage (12) pour agent de refroidissement.

7. Système de refroidissement selon la revendication 6, où ladite pression de travail est fournie par ledit moyen élastique (13) et ladite pression hydraulique dudit agent de refroidissement liquide est fournie par ladite pompe hydraulique (19).

8. Système de refroidissement selon l'une quelconque des revendications 1 à 7, où il comprend en outre un moyen (25) formant une barrière qui est disposé sur une surface dudit composant de circuit du type solide (11), entourant l'aire où ladite couche de composé thermiquement conducteur (15) est placée.

9. Système de refroidissement selon l'une quelconque des revendications 1 à 8, où ledit collecteur de refroidissement (20) peut être séparé en un élément inférieur (20a) possédant une ouverture (20c) et un élément supérieur (20b) qui est en mesure de fermer ladite ouverture dudit élément inférieur de manière étanche aux liquides.

10. Procédé de réalisation d'un moyen (15) formant un composé thermiquement conducteur afin de réduire et de stabiliser la résistance de contact thermique entre un premier élément (14) et un deuxième élément (11) possédant des première et deuxième surfaces respectives qui sont en regard l'une de l'autre et entre lesquelles ledit matériau formant un composé thermiquement conducteur est interposé, ledit premier élément et ledit deuxième élément étant pressés l'un contre l'autre, caractérisé par les opérations suivantes :

presser lesdits premier et deuxième éléments et ledit moyen formant un composé thermiquement conducteur qui se trouve entre eux les uns contre les autres avec une pression initiale (Pm) qui est sensiblement supérieure à la pression (Pc) nécessaire pour atteindre une résistance de contact thermique minimale dans ledit moyen formant un composé thermiquement conducteur, et

réduire ladite pression initiale (Pm) jusqu'à une pression de travail (Pa) qui est supérieure à la pression zéro (figure 3).

11. Procédé de réalisation d'un moyen formant un composé thermiquement conducteur dans un système de refroidissement utilisé avec une carte à circuit imprimé (10) qui possède au moins un composant de circuit du type solide (11), ledit système de refroidissement comportant un collecteur de refroidissement (20) à l'intérieur duquel un passage (12) pour agent de refroidissement est disposé, une pompe hydraulique (19) fonctionnellement connectée audit passage pour agent de refroidissement et servant à mettre sous pression un agent de refroidissement liquide afin qu'il s'écoule dans ledit passage pour agent de refroidissement, et un module de refroidissement disposé de façon à correspondre audit composant de circuit du type solide, ledit module de refroidissement comprenant un moyen de transfert de chaleur (14) fonctionellement connecté audit collecteur de refroidissement (20) de façon qu'au moins une partie dudit moyen de transfert de chaleur soit exposée à l'écoulement dudit agent de refroidissement liquide et de façon que de la chaleur puisse être transférée dudit moyen de transfert de chaleur audit agent de refroidissement liquide et un moyen élastique (13) connecté audit moyen de transfert de chaleur et audit collecteur d'agent de refroidissement, afin de solliciter élastiquement ledit moyen de transfert de chaleur à venir contre ledit composant de circuit du type solide avec une pression de travail (Pa) qui est supérieure à la pression zéro, ledit moyen thermiquement conducteur étant disposé entre ledit moyen de transfert de chaleur et ledit composant de circuit du type solide et établissant un contact thermique entre eux, ledit procédé étant caractérisé par les opérations suivantes :

presser ledit moyen de transfert de chaleur (14) contre ledit composant de circuit du type solide (11) alors que ledit moyen (15) formant un composé thermiquement conducteur se trouve entre eux, avec une pression initiale (Pm) qui est sensiblement supérieure à la pression (Pc) nécessaire pour atteindre une résistance de contact thermique minimale dans ledit moyen formant un composé thermiquement conducteur (figure 3), et

réduire ladite pression initiale jusqu'à ladite pression de travail (Pa), laquelle est inférieure à ladite pression initiale,

de sorte qu'une résistance de contact thermique réduite et stabilisée est réalisée entre ledit moyen de transfert de chaleur (14) et ledit composant de circuit du type solide (11) sous ladite pression de travail (Pa).

12. Procédé selon la revendication 11, où on fournit ladite pression initiale audit moyen formant un composé thermiquement conducteur en pressant ladite carte à circuit imprimé (10) contre ledit module de refroidissement.

13. Procédé selon la revendication 12, où on déplace ladite carte à circuit imprimé (10) en direction dudit module de refroidissement à l'aide d'un élévateur à table.

14. Procédé selon la revendication 11, où ledit collecteur de refroidissement (20) peut être séparé en un élément inférieur (20a) qui possède une ouverture et un élément supérieur (20b) qui est en mesure de fermer ladite ouverture dudit élément inférieur d'une manière étanche aux liquides, et on fournit ladite pression initiale audit moyen formant un composé thermiquement conducteur en poussant mécaniquement ledit moyen de transfert de chaleur contre ledit composant de circuit à l'aide d'un bâti de poussée que l'on insère à l'intérieur dudit collecteur de refroidissement inférieur en enlevant ledit collecteur de refroidissement supérieur.

15. Procédé selon la revendication 11, où on fait varier ladite pression initiale exercée sur ledit moyen (15) formant un composé thermiquement conducteur en réglant ladite pression hydraulique dudit agent de refroidissement à l'aide de ladite pompe hydraulique (19) et d'un moyen (26) permettant d'arrêter l'écoulement dudit agent de refroidissement.

FIG. 1

FIG. 2

FIG. 3

12

FIG. 4

20

X

12

13

14

15

11

10

FIG.5(a)

20

12

19

13

14

15

11

10

22

16

FIG.5(b)

20

12

19

13

14

15

11

10

22

16

FIG.6(a)

FIG.6(b)

FIG.7

FIG. 8